# EUROPÄISCHE PATENTANMELDUNG

(11) **EP 2 267 463 A2**
(43) Veröffentlichungstag der Anmeldung: **29.12.2010**
(21) Anmeldenummer: 10006115.9
(22) Anmeldetag: 12.06.2010
(51) Int. Cl.: G01R 11/04

(54) **Anschlussvorrichtung für einen Stromzähler**

(30) Priorität: 25.06.2009 DE 102009030659; 14.07.2009 DE 102009049851
(71) Anmelder: Hager Electro GmbH & Co. KG, 66440 Blieskastel (DE)
(72) Erfinder: Kelaiditis, Konstantin, Dr.-Ing., 66386 St. Ingbert (DE)
(74) Vertreter: Bernhardt, Reinold

(57) **Zusammenfassung**

Die Erfindung betrifft eine Anschlussvorrichtung für einen Stromzähler, insbesondere elektronischen Stromzähler, von dem durch Öffnungen in einer Zählertragplatte Anschlusskontaktelemente für wenigstens eine Stromphase vorstehen, die durch Verschiebung des Stromzählers auf der Tragplatte elektrisch mit hinter der Tragplatte auf einer Bodenbaugruppe angeordneten Anschlussleiterstücken (6,7) verbindbar sind. Erfindungsgemäß ist die Bodenbaugruppe zur wahlweisen Aufnahme mit Anschlusskabeln (25) oder Klemmanschlusselementen (5) verbundener Anschlussleiterstücke (6,7) vorgesehen.

## Beschreibung

Die Erfindung betrifft eine Anschlussvorrichtung für einen Stromzähler, insbesondere elektronischen Stromzähler, von dem durch Öffnungen in einer Zählertragplatte Anschlusskontaktelemente für wenigstens eine Stromphase vorstehen, die durch Verschiebung des Stromzählers auf der Tragplatte elektrisch mit hinter der Tragplatte auf einer Bodenbaugruppe angeordneten Anschlussleiterstücken verbindbar sind.

Eine solche Anschlussvorrichtung ist z.B. aus der EP 1 901 078 A2 bekannt. Auf der Bodenbaugruppe gehalterte Anschlussleiterstücke sind mit ebenfalls auf der Bodenbaugruppe angebrachten, Anschlussleisten bildenden Klemmanschlusselementen verbunden. Die EP 1 901 078 A2 beschreibt ferner eine solche Anschlussvorrichtung, an deren Anschlussleiterstücken aus der Vorrichtung nach oben und unten herausgeführte Anschlusskabel fest angebracht sind.

Der Erfindung liegt die Aufgabe zugrunde, eine neue Anschlussvorrichtung der eingangs erwähnen Art mit erweiterten Anwendungsmöglichkeiten zu schaffen.

Die diese Aufgabe lösende Anschlussvorrichtung nach der Erfindung ist **dadurch gekennzeichnet, dass** die Bodenbaugruppe zur wahlweisen Aufnahme mit Anschlusskabeln oder Klemmanschlusselementen verbundener Anschlussleiterstücke vorgesehen ist.

Erfindungsgemäß weist die Vorrichtung also eine je nach Anwendungsfall für unterschiedliche Bestückungen vorbereitete Bodenbaugruppe auf.

Während alle Klemmanschlusselemente auf einer Seite der Bodenbaugruppe angebracht oder sämtliche Anschlusskabel an einer Seite aus der Vorrichtung herausgeführt sein könnten, ist in einer bevorzugten Ausführungsform der Erfindung je Stromphase ein Anschlusskabel von der Kontaktstelle nach unten und ein Anschlusskabel von der Kontaktstelle nach oben geführt.

Zur Montage der Anschlusskabel sind diese jeweils in ein nach vorn sowie oben und unten offenes Aufnahmegehäuse für ein Klemmanschlusselement einlegbar. Das offene Gehäuse, das in der anderen Bestückungsvariante die Klemmanschlusselemente aufnimmt, dient als Führung für die Anschlusskabel.

In weiterer Ausgestaltung der Erfindung stehen von der Bodenbaugruppe die Anschlussleiterstücke gegen Verschiebung nach unten oder/und oben sichernde Halteelemente vor. Während diese Halteelemente lediglich Anschläge bilden können, greifen sie in einer bevorzugten Ausführungsform der Erfindung jeweils in eine Öffnung, vorzugsweise eine Durchgangsöffnung, in dem Anschlussleiterstück ein. Die mit den Anschlussleiterstücken verbundenen Anschlusskabel sind so auf Zug belastbar.

Vorzugsweise ist ein dem Anschlusskabel bzw. Klemmanschlusselement zugewandter Abschnitt der Anschlussleiterstücke jeweils als U-Profil ausgebildet, das dem Anschlussleiterstück eine hohe Stabilität verleiht.

In einem sich an den U-Profilabschnitt anschließenden Abschnitt können die beiden U-Schenkel des U-Profils vom Bodenschenkel des U-Profils getrennt sein und zu einer Kontaktstelle hin zusammenlaufende Klemmschenkel bilden, zwischen denen die oben genannten Anschlusskontaktelemente des Stromzählers im angeschlossenen Zustand des Stromzählers zur Anordnung kommen.

Zweckmäßig ist der von den Klemmschenkeln getrennte Bodenschenkel des U-Profils über die freien Enden der Klemmschenkel hinaus verlängert und bildet wenigstens einen zu den Klemmschenkeln seitlich versetzten Überbrückungskontakt zur Überbrückung der Anschlussleiterstücke je Stromphase im nicht angeschlossenen Zustand des Stromzählers.

Bei dem Überbrückungskontakt handelt es sich zweckmäßig um eine sich in Verschiebungsrichtung des Überbrückungselements bzw. Stromzählers erstreckende Kontaktschiene.

Für die Überbrückung kann ein Schieberelement, das sich parallel und im Abstand zu den Anschlussleiterelementen des Stromzählers durch Verschiebung des Stromzählers verschieben lässt, eingesetzt werden.

Vorteilhaft können die oben beschriebenen Anschlussleiterstücke einstückig aus einem einzigen Blechstanzteil hergestellt sein.

Vorzugsweise sind die Anschlussleiterstücke symmetrisch zu einer Längsachse, die sich in Verschiebungsrichtung des Stromzählers bzw. Überbrückungselements erstreckt, ausgebildet.

Die Erfindung wird nachfolgend anhand eines Ausführungsbeispiels und der beiliegenden, sich auf dieses Ausführungsbeispiel beziehenden Zeichnungen weiter erläutert. Es zeigen:
- Fig. 1: eine Bodenbaugruppe einer Stromzähleranschlussvorrichtung nach der Erfindung, die mit Anschlussleiterstücken bestückt ist, welche mit einem Schraubklemmelement verbunden sind,
- Fig. 2: die genannten Anschlussleiterstücke und Schraubklemmanschlusselemente ohne die Bodenbaugruppe,
- Fig. 3: eine Teilansicht von zwei, einer Stromphase zugehörenden Leiterstücken,
- Fig. 4: die Bodenbaugruppe von Fig. 1 alternativ bestückt mit Anschlussleiter- stücken, welche jeweils mit einem Anschlusskabel verbunden sind, und
- Fig. 5: die Anschlussleiterstücke und Anschlusskabel von Fig. 5 ohne die Boden- baugruppe.

Eine aus Kunststoff bestehende Bodenbaugruppe einer Anschlussvorrichtung für einen elektronischen Stromzähler weist eine Bodenplatte 1 und von der Bodenplatte vorstehende Seitenwände 2 und 3 auf. Die Bodenbaugruppe nimmt eine Zählertragplatte für einen darauf aufsetzbaren Stromzähler und eine zwischen der Zählertragplatte und der Bodenbaugruppe angeordnete Schieberplatte auf. Den (nicht gezeigten) Platten entsprechende Platten sind in der hier einbezogenen EP 1 901 078 A2 beschrieben.

Sowohl am oberen als auch unteren Ende der Bodenbaugruppe sind Aufnahmegehäuse 4 für je ein Schraubklemmanschlusselement 5 gebildet. Die vier, jeweils an drei Seiten offenen Aufnahmegehäuse bilden mit den darin angeordneten Schraubklemmanschlusselementen 5 eine Anschlussleiste.

Jeweils drei der Schraubklemmelemente 5 sind mit einem Anschlussleiterstück 6 bzw. 7 verbunden. Insgesamt sind drei Paare, je einer Stromphase zugehörende Anschlussleiterstücke 6,7 vorgesehen. Von der Bodenplatte 1 stehen verschiedene Halte- und Führungselemente vor, um die Anschlussleiterstücke 6,7 an Ort und Stelle zu halten.

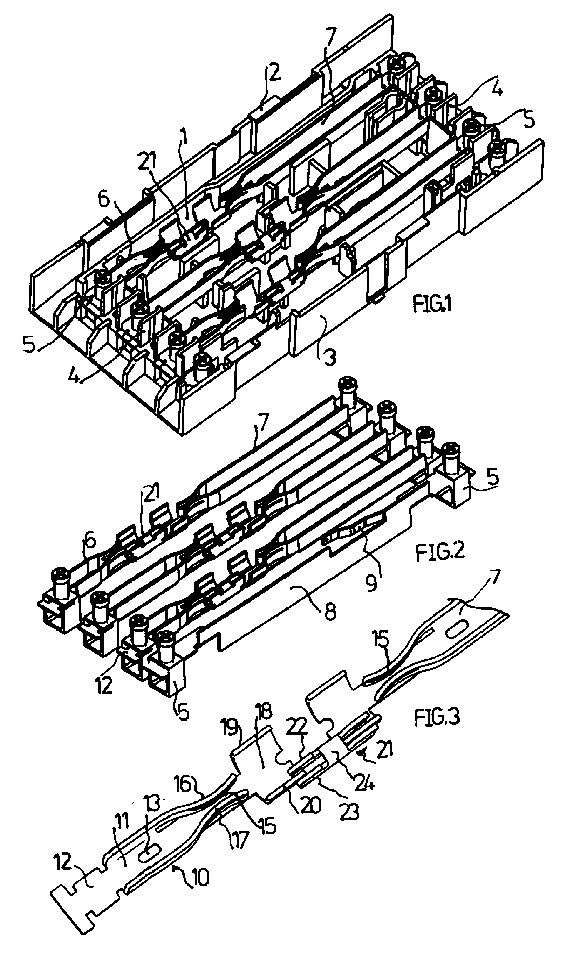

Wie Fig. 2 erkennen lässt, ist jeweils eines der vier Klemmanschlusselemente 5 am oberen und unteren Ende der Bodenbaugruppe mit einem durchgehenden Leiterstück 8 verbunden, das einem Neutralleiter zugehört. Eine elastisch abbiegbare Kontaktfahne 9 des Leiterstücks 8 dient der elektrischen Verbindung mit einem Anschlusskontaktelement des Stromzählers.

Wie insbesondere Fig. 3 erkennen lässt, weisen die Anschlussleiterstücke 6,7 jeweils einen U-förmigen Abschnitt 10 auf, welcher dem betreffenden Schraubklemmanschlusselement 5 zugewandt ist. Ein Bodenschenkel 11 des U-förmigen Abschnitts 10 ist um eine in dem Schraubklemmanschlusselement 5 einklemmbare Kontaktfahne 12 erweitert.

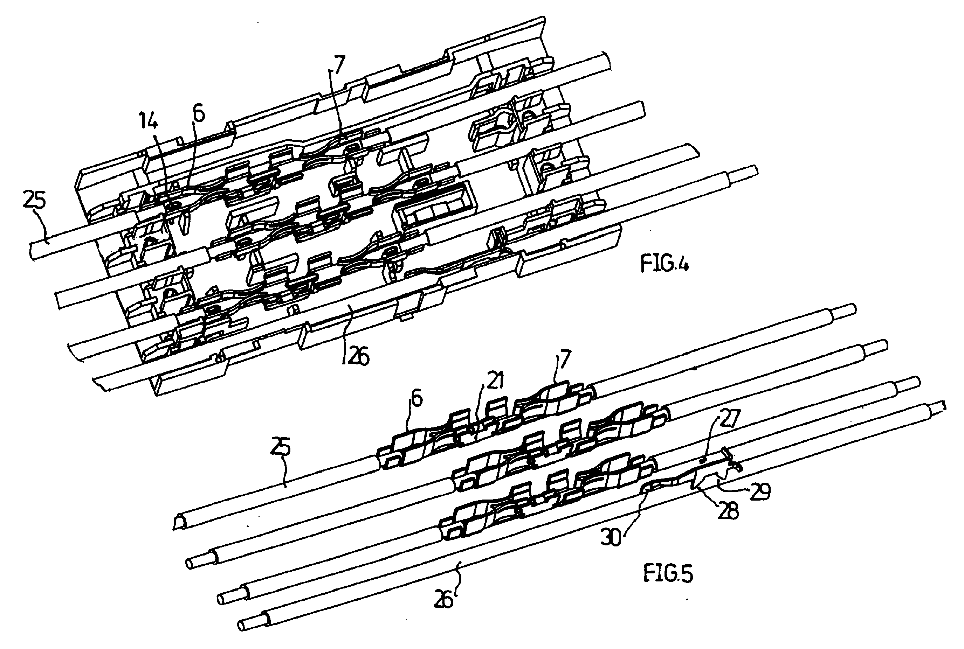

Ferner ist in dem Bodenschenkel 11 eine Durchgangsöffnung 13 für den Eingriff eines vom Boden 1 der Bodenbaugruppe vorstehenden Halteelements 14 (siehe Fig. 4) gebildet.

Wie Fig. 3 ferner zeigt, schließt sich an den U-förmigen Profilabschnitt 10 in Längsrichtung des Anschlussleiterstücks ein weiterer Abschnitt an, in welchem die U-Schenkel von dem Bodenschenkel 11 getrennt sind und Klemmschenkel 16 und 17 bilden, die zu einer Kontaktstelle 15 hin zusammenlaufen.

Der Bodenschenkel 11 ist über die freien Enden der Klemmschenkel 16 und 17 hinaus verlängert und bildet eine gegenüber dem Klemmschenkelpaar verbreiterte Kontaktfahne 18 mit abgewinkelten Kontaktschienen 19 und 20, die sich in Längsrichtung des Anschlussleiterstücks erstrecken.

Wie Fig. 3 zeigt, wird die Kontaktschiene 20 als Überbrückungskontakt genutzt, indem die Kontaktschiene 20 zwischen zwei Platten 22 und 23 eines Überbrückungselements 21 eingeklemmt ist. Die Platten 22 und 23 des Überbrückungselements 21 sind randseitig über einen in der Längsmitte der Platte angeordneten Steg 24 verbunden. Fig. 3 zeigt den Überbrückungszustand, in dem die Platten 22 und 23 neben der Kontaktschiene 20 eine entsprechende Kontaktschiene des Anschlussleiterstücks 7 zwischen sich einklemmen.

Im nicht angeschlossenen Zustand des Stromzählers sind die Leiterstücke 6,7 durch die Überbrückungselemente 21, wie gezeigt, elektrisch miteinander verbunden, so dass (ungezählter) Strom fließen kann. Bei Anschluss des Stromzählers wird die genannte Schieberplatte durch vom Stromzähler vorstehende, Öffnungen in der Schieberplatte durchstoßende Anschlusskontaktelemente mitgenommen, wobei die Schieberplatte ihrerseits die Überbrückungselemente 21 mitnimmt. Durch Verschiebung des Stromzählers auf der Zählertragplatte gelangen die genannten Anschlusskontaktelemente an die Kontaktstellen 15 zwischen den betreffenden Klemmschenkeln 16,17, während gleichzeitig die Überbrückung durch das Überbrückungselement 21 aufgehoben wird, wie dies in der hier einbezogenen EP 1 901 078 A2 beschrieben ist.

Fig. 4 zeigt eine zweite Bestückungsvariante der vorangehend beschriebenen Bodenbaugruppe.

Anstelle mit einem Klemmanschlusselement verbundener Leiterstücke sind Leiterstücke 6,7 jeweils mit einem Anschlusskabel 25 verbunden, wobei drei Anschlusskabel nach unten und drei Anschlusskabel nach oben aus der Bodenbaugruppe herausgeführt sind. Ein viertes, einem Neutralleiter zugehöriges Kabel 26 verläuft durchgehend durch die Bodenbaugruppe.

Ein mit dem Kabel 26 verbundenes Anschlussstück 27 weist zwei dreieckförmige Messer mit zueinander geneigten und im Abstand angeordneten Schneidkanten 28 und 29 auf. Eine Kontaktfahne 30 dient zur Verbindung mit einem vom Stromzähler vorstehenden Anschlusskontaktelement gegen das die Kontaktaufnahme elastisch anliegt. Die Messer dringen in die Litzenstruktur des Kabels 26 ein. Einem durch das genannte Anschlusskontaktelement ausgeübten Drehmoment setzen die im Abstand zueinander angeordneten, in die Litzenstruktur eingedrungenen Messer ein Haltemoment entgegen.

Wie Fig. 4 erkennen lässt, sind die Anschlusskabel 25 sowie das Neutralleiterkabel 26 jeweils in die an drei Seiten offenen Aufnahmegehäuse für die Klemmanschlusselemente eingelegt und durch dies geführt.
In die Durchgangsöffnungen 13 in den Anschlussleiterstücken 6,7 eingreifende von dem Boden 1 vorstehende Halteelemente 14 ermöglichen eine Zugbelastung der Kabel 25.

## Patentansprüche

1. Anschlussvorrichtung für einen Stromzähler, insbesondere elektronischen Stromzähler, von dem durch Öffnungen in einer Zöhlertragplatte Anschlusskontaktelemente für jeweils eine Stromphase vorstehen, die durch Verschiebung des Stromzählers auf der Tragplatte elektrisch mit hinter der Tragplatte auf einer Bodenbaugruppe (1-3) angeordneten Anschlussleiterstücken (6,7) verbindbar sind,
**dadurch gekennzeichnet,**
**dass** die Bodenbaugruppe (1-3) zur wahlweisen Aufnahme mit Anschlusskabeln (25) oder Klemmanschlusselementen (5) verbundener Anschlussleiterstücke (6,7) vorgesehen ist.

2. Anschlussvorrichtung nach Anspruch 1,
**dadurch gekennzeichnet,**
**dass** je Stromphase ein Anschlussleiterstück (6) von der betreffenden Kontaktstelle (15) nach unten und ein Anschlussleiterstück (7) von der betreffenden Kontaktstelle (15) nach oben geführt ist.

3. Anschlussvorrichtung nach Anspruch 1 oder 2,
**dadurch gekennzeichnet,**
**dass** die Anschlusskabel (25) jeweils in ein nach vorn sowie oben und unten offenes Aufnahmegehäuse (4) für ein Klemmanschlusselement (5) einlegbar sind.

4. Anschlussvorrichtung nach einem der Ansprüche 1 bis 3,
**dadurch gekennzeichnet,**
**dass** vom Boden (1) der Bodenbaugruppe (1-3) die Anschlussleiterstücke (6,7) gegen Verschiebung nach unten oder/und oben sichernder Halteelemente (14) vorstehen.

5. Anschlussvorrichtung nach Anspruch 4,
**dadurch gekennzeichnet,**
**dass** die Halteelemente (14) jeweils in eine Öffnung, vorzugsweise Durchgangsöffnung (13), in dem Anschlussleiterstück (6,7) eingreifen.

6. Anschlussvorrichtung nach einem der Ansprüche 1 bis 5,
**dadurch gekennzeichnet,**
**dass** ein dem Anschlusskabel (25) bzw. Klemmanschlusselement (5) zugewandter Abschnitt (10) der Anschlussleiterstücke (6,7) jeweils als U-Profil ausgebildet ist.

7. Anschlussvorrichtung nach Anspruch 6,
**dadurch gekennzeichnet,**
**dass** in einem sich an dem U-Profilabschnitt (10) anschließenden Abschnitt die beiden U-Schenkel des U-Profils vom Bodenschenkel (11) des U-Profils getrennt sind und zu einer Kontaktstelle (15) hin zusammenlaufende Klemmschenkel (16,17) bilden.

8. Anschlussvorrichtung nach Anspruch 7,
**dadurch gekennzeichnet,**
**dass** der Bodenschenkel (11) über die freien Enden der Klemmschenkel (16,17) hinaus verlängert ist und wenigstens einen zu den Klemmschenkeln (16,17) seitlich versetzten Überbrückungskontakt (19,20) bildet.

9. Anschlussvorrichtung nach Anspruch 8,
**dadurch gekennzeichnet,**
**dass** der Überbrückungskontakt als sich in Verschiebungsrichtung des Stromzählers erstreckende Kontaktschiene (19,20) ausgebildet ist.

10. Anschlussvorrichtung nach einem der Ansprüche 1 bis 9,
**dadurch gekennzeichnet,**
**dass** die Anschlussleiterstücke (6,7) einstückig aus einem einzigen Blechstanzteil geformt sind.

11. Anschlussvorrichtung nach einem der Ansprüche 1 bis 10,
**dadurch gekennzeichnet,**
**dass** die Anschlussleiterstücke (6,7) symmetrisch in Bezug auf eine Längsachse ausgebildet sind.
